(19) Europäisches Patentamt

European Patent Office

Office européen des brevets

(11) Veröffentlichungsnummer: **0 657 746 A2**

# (12) EUROPÄISCHE PATENTANMELDUNG

(21) Anmeldenummer: **95102680.6**

(22) Anmeldetag: **27.08.92**

(51) Int. Cl.⁶: **G01R 33/025**, G01C 17/38

Diese Anmeldung ist am 24 - 02 - 1995 als Teilanmeldung zu der unter INID-Kode 60 erwähnten Anmeldung eingereicht worden.

(30) Priorität: **17.09.91 EP 91115776**

(43) Veröffentlichungstag der Anmeldung:
**14.06.95 Patentblatt 95/24**

(60) Veröffentlichungsnummer der früheren Anmeldung nach Art. 76 EPÜ: **0 604 466**

(84) Benannte Vertragsstaaten:

AT BE CH DE DK ES FR GB IT LI LU NL SE

(71) Anmelder: **SIEMENS AKTIENGESELLSCHAFT**
**Wittelsbacherplatz 2**
**D-80333 München (DE)**

(72) Erfinder: **Brehler, Markus**
**Wackersbergerstrasse 33**
**D-81371 München (DE)**
Erfinder: **Feigen, Patrick**
**Liesl-Karlstadt-Strasse 19**
**D-81476 München (DE)**

(54) **Verfahren zur Kompensation eines magnetischen Störfeldes in einem Fahrzeug.**

(57) Verfahren zur Kompensation eines Magnetstörfeldes in einem Fahrzeug, das eine Navigationseinrichtung aufweist.

Aus den Meßwerten der Magnetfeldsonde wird während einer Eichfahrt für eine Erstkompensation ein erster Satz von Störfeldparametern ermittelt (Störfeldvektor V1, Achsen a,b der elliptischen Ortskurve E1, Schräglagewinkel δ) und auf Punkte einer kreisförmigen Ortskurve (K1) mit dem Radius a um den Koordinaten-Nullpunkt (0) transformiert. Während der Fahrt wird zu jedem Meßwertpaar (MP mit jeweiligen X- und Y-Werten) der Abstand von Nullpunkt (0) und der Winkel berechnet. In einen Segmentspeicher für 360° mit einer Vielzahl von Speicherzellen (vorgegebener Winkelbereich z.B. 15°) werden die berechneten Radiuswerte und die kreistransformierten Meßwertpaare (MP) in ihre zugehörige Speicherzelle einge-mittelt. Für jedes Segment wird die Radiusdifferenz (Δa) aus den gemittelten Radiuswerten und dem Radius (a) ermittelt und gefiltert; daraus wird das Maximum (MAX) nach Richtung und Betrag und der neue Mittelpunkt (M2) der Ortskurve (K2) und somit der neue Störfeldvektor (V2 = V1 + V2') berechnet. Von M2 aus werden die Abstände zu den Meßwertpunkten (MP) berechnet und mit dem Radius verglichen, bei hinreichend genauer Übereinstimmung wird mit dem neuen Störfeldvektor (V2) kompensiert.

FIG 1

FIG 2

Die Erfindung bezieht sich auf ein Verfahren zur Kompensation eines magnetischen Störfeldes in einem Fahrzeug gemäß dem Oberbegriff des Anspruchs 1.

Für die Leitweglenkung eines Fahrzeuges ist es erforderlich, die Richtung des Erdmagnetfeldes in bezug auf das Fahrzeug zu ermitteln. Das Magnetfeld wird mit einem im Fahrzeug fest eingebauten Magnetometer, z.B. einer Magnetfeldsonde, gemessen. Wahrend einer Eichfahrt, z.B. Kreisfahrt, werden die Parameter der Ortskurve (E1), nämlich einer Ellipse, des Magnetfeldes nach einem bekannten Verfahren ermittelt. Die Parameter der elliptischen Ortskurve (E1) sind die beiden Halbachsen a und b, die Verdrehung um einen bestimmten Winkel ($\delta$), welche die Form beschreiben, und die Verschiebung aus dem Koordinatenursprung, wie dies bereits aus der EP-A-0 382 290 bereits bekannt ist. Diese Verschiebung wird als "Störfeldvektor" (V1) bezeichnet (Fig. 1).

Eine Analyse der gesammelten Meßdaten der Magnetfeldsonde hat ergeben, daß der Störfeldvektor (V1) sich aufgrund äußerer Einflüsse sprunghaft ändert, während die Form (a,b,$\delta$) der Ortskurve in der Regel konstant bleibt. Solche Einflüsse sind beispielsweise das Bewegen eines Stahlschiebedaches oder eines Glasschiebedaches mit Stahlrahmen, sich ändernde Straßenneigungen, die senkrecht zur Fahrtrichtung verlaufen, das Ein- oder Ausladen metallischer Last im Fahrzeug, wie beispielsweise die Heckscheibenheizung. Diese Änderungen sind langer andauernd oder langsam verlaufend, etwa im Minutenbereich. Sie müssen von kurzfristigen Störungen bzw. Störfeldern, die von Untergrund-, Straßenbahnen oder vorbeifahrenden LKW's verursacht sind, unterschieden werden.

Es wurden daher schon verschiedene Kompensationsverfahren beschrieben. Beispielsweise ist aus der DE-OS 36 44 681 ein Navigationsverfahren für Fahrzeuge mit elektrischem Kompaß bekannt, bei dem mit einem dynamischen Nachziehverfahren hartmagnetische Einflüsse in der Umgebung des Magnelfeldsensors kompensiert werden. Bei dem bekannten Verfahren wird ein gewichteter Störfeldvektor zum Störvektor addiert. Dabei ist es jedoch nachteilig, daß die Unterscheidung zwischen kurzen und länger dauernden Störfeldern nur ausschließlich mit Hilfe des Wichtungsfaktors erfolgt. Wird der Wichtungsfaktor gemäß dem bekannten Verfahren zu 0,1 bei einer Zykluszeit von 100 msec gewählt, so gehen viele kurzfristige Störungen, wie oben erwähnt, vollständig in die Störvektorverschiebung ein und verfälschen somit das Ergebnis der Navigation nachhaltig. Wird der Wichtungsfaktor hingegen so klein gewählt, daß der obige Effekt nicht auftritt, so gehen die kurzfristigen Störfelder trotzdem, wenn auch schwächer, in das Eergebnis ein. Außerdem dauert das Nachziehen dann sehr lange, etwa im Zehn-Minuten-Bereich, so daß die Navigation unzumutbar lange gestört ist.

Aufgabe der Erfindung ist es daher, ein Verfahren zur Kompensation von magnetischen Störfeldern zu verbessern, welche durch sprunghafte Änderungen hervorgerufen werden und zu länger andauernden Störungen führen. Dabei sollen kurzfristige Störungen, die ebenfalls zu einer Änderung des gemessenen Magnetfeldes führen, unterdrückt werden, um dadurch Mißweisungen zu vermeiden.

Diese Aufgabe wird bei dem hier beschriebenen Kompensationsverfahren mit den Merkmalen des Anspruchs 1 oder 2 gelöst.

Das erfindungsgemäße Verfahren weist folgende Verfahrensschritte auf:

Die Ortskurve ist von den Meßwerten der Magnetfeldsonde gebildet. Diese Meßwerte liegen auf einer Ellipse (E1). Während einer Eichfahrt werden für eine Erstkompensation die Störfeldparameter (Parameter dieser Ellipse E1) ermittelt, das sind die Mittelpunktskoordinaten (M1), die Achsen a und b und die Schräglage $\delta$. Alle Meßwerte (elliptische Ortskurve E1) werden auf eine kreisförmige Ortskurve (Kreis K1) mit dem Radius a und dem Koordinatenursprung (0 = M1) transformiert. Alle weiteren Verfahrensschritte finden in diesem transformierten System statt. Mit Filtern und durch Vertrauensbereich-Prüfungen werden kurzfristige Störfeldänderungen erkannt und die dazugehörigen Magnetfeldsonden-Meßwerte ausgesondert. Für jedes Meßwertpaket (Meßwerte X und Y) werden Winkel und Radius berechnet. Der Radius wird in einem Segmentspeicher entsprechend dem zugehörigen Winkel abgelegt. Dieser Segmentspeicher umfaßt den gesamten Winkelbereich von 0° bis 360°, wobei eine Vielzahl von Winkelbereichen, beispielsweise jeweils 15°, mit zugehörigen Speicherzellen gebildet sind. Alle Radien, die in gleiche Speicherzellen des Segmentspeichers abgelegt sind, werden gemittelt. Zusätzlich werden noch die Mittelwerte aller zu einem Winkelbereich gehörenden Meßwertpaare gebildet und abgespeichert. Sobald eine ausreichende Menge von Meßwerten vorliegt und eine bestimmte Anzahl von Winkelbereichen überstrichen ist, wird das im folgenden beschriebene Verfahren durchgeführt.

Erfindungsgemäß wird für jeden Winkelbereich die Radiusdifferenz aus dem gemittelten Radiuswert und dem Radiuswert des ursprünglichen Kreises berechnet. Die Radiusdifferenzwerte werden mittels eines Tiefpasses gefiltert und danach wird das Maximum des Betrages bestimmt. Einen neuen Mittelpunkt der Ortskurve erhält man durch Verschieben des alten Mittelpunktes um Betrag und zugeordnete Richtung des vorher bestimmten Maximums. In einem weiteren Schritt werden vom neuen Kreismittelpunkt aus die Abstände zu den gespeicherten Meßwert-Mittelwerten berechnet und mit dem Radius des ursprünglichen Kreises aus der Erstkompensation verglichen, wobei bei hinreichend genauer Übereinstimmung der neu ermittelte Störfeldvektor als gültig erklärt wird. Ist keine hinreichend genaue Übereinstimmung gegeben, so wird das Segment, das dem Maximum entspricht, als ungültig erklärt und der Vorgang wird mit den verbleibenden Segmenten wiederholt. Das geschieht so häufig, bis entweder ein passender Wert gefunden wurde oder ein maximaler Prozentsatz aller verwendeten Segmentbereiche verbraucht ist.

Dabei werden erst während einer gewissen Zeit Meßwerte gesammelt und verarbeitet, bevor der eigentliche Vorgang der Kompensations-Anpassung durchgeführt wird. Falls während dieser Phase erkennbare Störungen auftreten, wird die Meßwert-Sammelphase abgebrochen und neu begonnen. Hierbei wird der Zeitpunkt des Kompensationsverfahrens durch folgende Kriterien bestimmt: Eine bestimmte Anzahl von Meßwerten sind eingelaufen und eine bestimmte Anzahl von Winkelsegmenten wurden beschrieben. Bei einer Verbesserung des Verfahrens werden verschiedene Kombinationen von einer bestimmten Anzahl von Meßwerten und Winkelsegmenten zugelassen, von denen mindestens eine erfüllt sein muß. Der Grund dafür besteht in folgendem Sachverhalt: Ein Fahrzeug fährt längere Zeit im wesentlichen geradeaus, es werden viele Meßwerte in einem kleinen Winkelbereich gesammelt. In einem anderen Fall fährt ein Fahrzeug eine 90°-Kurve, wobei wenige Meßwerte in relativ viele Winkelbereiche eingetragen werden. In beiden Fällen sollte eine versuchsweise Neukompensation möglich sein.

In einer Weiterbildung des erfindungsgemäßen Verfahrens wird schon während der Datensammelphase geprüft, wie gut der aktuelle Störfeldvektor den momentanen Meßwerten entspricht, d.h. es wird die Güte des Störfeldvektors bestimmt. Dabei werden die Radien der Meßwerte mit dem Sollradius verglichen. Wird eine stärkere Abweichung festgestellt, so können die Meßwerte zwischengespeichert werden und nach der nächsten Kompensationsanpassung kann die Position rückwirkend korrigiert werden.

Anhand einer Zeichnung wird das erfindungsgemäße Verfahren erläutert, dabei zeigen

Figur 1 eine elliptische Ortskurve des Magnetfeldes und deren Verschiebung in einem kartesischen Koordinatensystem und

Figur 2 eine verschobene, auf den Kreis transformierte Ortskurve aufgrund des Störfeldes für die Berechnung mittels Maximum und Mustererkennung.

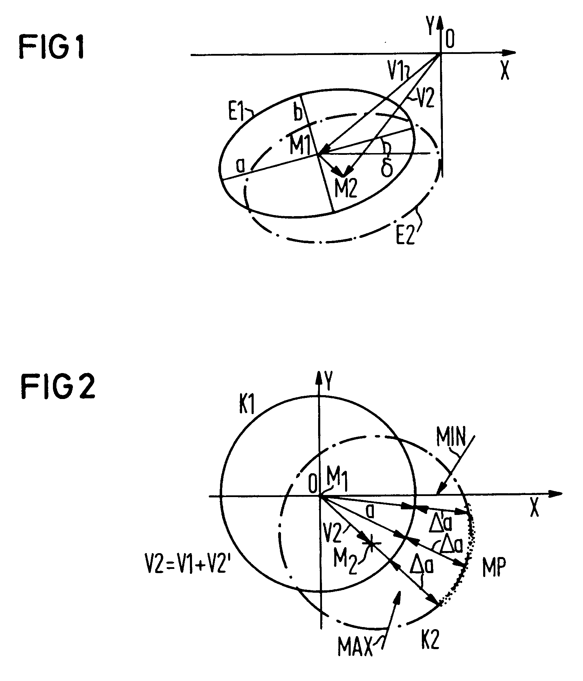

In Figur 1 ist der bekannte Eichvorgang veranschaulicht. Während einer Eichfahrt werden die Parameter der Ortskurve - Ellipse E1- des Magnetfeldes ermittelt und gespeichert. Damit ist diese Ortskurve E1 mit ihren Parametern, den Halbachsen a,b und der Winkeldrehung $\delta$ bekannt und aufgrund des Störfeldes aus den Koordinatenursprung 0 heraus verschoben, so daß vom Koordinatenursprung 0 aus zum Mittelpunkt M1 der Ellipse E1 der Störfeldvektor V1 berechnet werden kann. Eine sprunghafte Änderung des Magnetfeldes führt erneut zu einer weiteren Verschiebung der elliptischen Ortskurve, was in der Figur 1 durch die gestrichelte Ellipse E2 angedeutet ist, die dann den Mittelpunkt M2 aufweist. Aufgabe der Erfindung ist es nun, die sprunghafte Änderung des Störfeldes (Vektor M1-M2) und damit den neuen Störfeldvektor V2 zu ermitteln.

Anhand von Figur 2 soll das erfindungsgemäße Verfahren zur Ermittlung des Störfeldvektors veranschaulicht werden. Wie eingangs erläutert, werden die Meßwerte (X,Y), die in ein bestimmtes Segment (Winkelbereich von z.B. 15°) fallen, mit ihrem Radiuswert eingemittelt. Der Kreis K1 entspricht der Ortskurve aus der Erstkompensation mit dem Radius a und dem Mittelpunkt M1 im Ursprung 0, der mit der Eichfahrt ermittelt wurde. Bei der Weiterfahrt des Fahrzeuges und bei einer Verursachung einer sprunghaften Magnetfeldänerung, z.B. hervorgerufen durch das Öffnen des Stahlschiebedaches, ergibt sich eine neue Ortskurve K2 mit einer Reihe von Meßwertpunkten MP, die durch dis sprunghafte Störung hervorgerufen wurden und im Bereich des Kreisbogens liegen. Gemäß der Erfindung wird nun für jedes Segment der Radiusdifferenzwert $\Delta a$ aus den gemittelten Radiuswerten und dem Radius a des ursprünglichen Kreises K1 berechnet. Um Streuwerte der Meßwertpunkte MP auszuschließen, werden die Radius-Differenzwerte mittels eines Tiefpasses gefiltert. Aus den gefilterten Radius-Differenzwerten wird nun das Maximum MAX nach Betrag und Richtung bestimmt und daraus der Mittelwert MR der neuen Ortskurve K2 berechnet. Daraus wird nun der neue Störfeldvektor V2 (aus Fig. 1) berechnet, mit dem weitere Kompensation durchgeführt werden soll.

Bevor jedoch mit diesem neuen Störfeldvektor V2 kompensiert wird, wird noch eine Mustererkennung gestartet. Dazu werden die Abstände der gespeicherten, auf den Kreis K2 transformierten Meßwertpunkte MP vom neuen Kreismittelpunkt M2 ausgehend berechnet. Dabei sollen diese Abstände hinreichend genau mit dem Radius a des Kreises K1 aus der Erstkompensation übereinstimmen. Isat diese Bedingung erfüllt, so wird endgültig mit dem neuen Störfeldvektor V2 gearbeitet. Andernfalls wird das berechnete Maximum als unbrauchbar bezeichnet und ein neues Maximum gesucht. Der gesamte Vorgang wird solange wiederholt, bis entweder ein brauchbares Maximum gefunden ist, oder mehr als eine bestimmte Anzahl der beschriebenen Winkelsegmente als unbrauchbar gekennzeichnet sind. Das erfindungsgemäße Verfahren hat den Vorteil, daß beim Auftreten einer sprunghaften Störung des Magnetfeldes eine sprunghafte schnelle Anpassung an den neuen magnetischen Ströfeldvektor erfolgt. Eine sukzessive Anpassung über einen Richtungsfaktor ist somit nicht erforderlich.

Bei dem erfindungsgemäßen Verfahren kann aufgrund des Vergleichs der Radiuswerte aller eingehenden Magnetfeldmeßwerte mit dem Radius aus der Erstkompensation die Güte des Störfeldvektors bestimmt werden. Von dem Moment an, an dem die Güte des Störfeldvektors abnimmt, werden alle Originalmeßwerte von der Magnetfeldsonde und vom Radsensor (Wegimpulse) abgespeichert. Nach einer erfolgreichen Korrektur des Störfeldvektors, d.h. wenn die Güte des Störfeldvektors wieder hinreichend gut ist, kann aufgrund der gespeicherten Daten die Position des Fahrzeugs nachträglich kompensiert werden.

## Patentansprüche

1. Verfahren zur Kompensation eines Magnetstörfeldes in einem Fahrzeug, in dem für Navigationszwecke mittels einer Magnetfeldsonde und einer Meß- und Auswerteeinrichtung die Richtung des Erdmagnetfeldes und mit einem Radsensor die gefahrene Wegstrecke ermittelt und in einem Navigationsrechner verarbeitet werden, mit folgenden Verfahrensschritten:

   aus den Meßwerten der Magnetfeldsonde wird während einer Eichfahrt (z.B. Kreisfahrt) für eine Erstkompensation ein erster Satz von Störfeldparametern ermittelt, die aus den Werten für den Störfeldvektor (V1), den Achsen (a,b) der elliptischen Ortskurve (E1) und der Schräglage ($\delta$) dieser Ortskurve (E1) bestehen, welche in eine kreisförmige Ortskurve (K1) mit dem Radius a um den Koordinatenursprung (Nullpunkt 0) transformiert wird;

   während der Fahrt werden alle Meßwerte (Meßwertpaare X und Y) unter Berücksichtigung eines Satzes von Störfeldparametern auf Punkte (X,Y) einer neuen (X,Y) kreisförmigen Ortskurve (K2) transformiert;

   zu jedem transformierten Meßwertepaar (X;Y) wird der Abstand vom Nullpunkt (Radius) und der Winkel berechnet;

   ein Segmentspeicher für den Bereich von 0°-360° wird definiert, wobei jede Speicherzelle einem vorgegebenen Winkelbereich (Segment mit z.B. 15°) entspricht;

   die berechneten Radiuswerte und die kreistransformierten Meßwertpaare (MP) werden in die ihrem Winkel entsprechenden Speicherzellen eingemittelt;

   **gekennzeichnet durch** folgende Verfahrensschritte:

   für jedes Segment wird die Radiusdifferenz ($\Delta a$) aus den gemittelten Radiuswerten und dem Radius (a) des ursprünglichen Kreises (K1) ermittelt;

   die Radiusdifferenzwerte werden mitels eines Tiefpasses gefiltert;

   aus den gefilterten Radius-Differenzwerten wird das Maximum (MAX) nach Richtung und Betrag und hieraus der neue Mittelpunkt (M2) der Ortskurve (K2) und somit der neue Störfeldvektor (V2) berechnet;

   vom neuen Kreismittelpunkt (M2) aus werden die Abstände zu den gespeicherten Meßwertpunkten (MP) berechnet und mit dem Radius (a) des ursprünglichen Kreises (K1) verglichen, wobei der neue Störfeldvektor (V2) bei hinreichend genauer Übereinstimmung in den Satz der Störfeldparameter aufgenommen und bei der Transformation von Meßwerten berücksichtigt wird.

2. Verfahren nach Anspruch 1,
   **dadurch gekennzeichnet,** daß der neue Störfeldvektor (V2) nur berechnet wird, wenn eine Mindestanzahl von Meßwerten überschritten und gleichzeitig eine Mindestanzahl von Winkelbereichen im Segmentspeicher beschrieben ist.

3. Verfahren nach Anspruch 2,
   **dadurch gekennzeichnet,** daß eine von mehreren vorgegebenen Kombinationen von Meßwertmindestzahl und Mindetanzahl von beschriebenen Winkelbereichen im Segmentspeicher erfüllt sein muß.

4. Verfahren nach einem der vorhergehenden Ansprüche,
   **dadurch gekennzeichnet,** daß aus dem Vergleich der Radiuswerte aller eingehenden Magnetfeld-Meßwerte mit dem Radius der Ortskurve aus der Erstkompensation die Güte des Störfeldvektors bestimmt wird und bei der Abnahme der Güte unter einem bestimmten Wert alle originalen Meßwerte von der Magnetfeldsonde und vom Radsensor (Wegimpulse) gespeichert werden, um nachträglich mit dem neuen Störfeldvektor die Fahrzeugposition unter Ausnutzung der gespeicherten Daten zu korrigieren.

FIG 1

FIG 2